# EUROPEAN PATENT SPECIFICATION

(11) **EP 4 109 206 B1**
(45) Date of publication and mention of the grant of the patent: **18.11.2026**
(21) Application number: 21207136.9
(22) Date of filing: 09.11.2021
(51) Int. Cl.: G06F 1/16, H04M 1/02

(54) **DRIVING MECHANISM AND ELECTRONIC DEVICE**
ANTRIEBSMECHANISMUS UND ELEKTRONISCHE VORRICHTUNG
MÉCANISME D'ENTRAÎNEMENT ET DISPOSITIF ÉLECTRONIQUE

(30) Priority: 25.06.2021 CN 202110711442
(43) Date of publication of application: 28.12.2022
(73) Proprietor: Beijing Xiaomi Mobile Software Co., Ltd., Beijing 100085 (CN)
(72) Inventor: LIU, Zhenhua, Beijing 100085 (CN); LI, Pengfei, Beijing 100085 (CN)
(74) Representative: dompatent

(56) References cited:
- CN-A- 112 153 180
- CN-A- 112 866 451
- CN-U- 209 120 296
- US-A1- 2020 267 246
- US-A1- 2020 267 247

## Description

### BACKGROUND

With the continuous advancement of screen technology, large-scale production of foldable flexible screens, and advent of 0.01mm flexible display screens all over the world, form of terminal products becomes increasingly diverse. From smart wears to smart homes and to smart phone terminals, ultra-thin flexible screens lead to multi-directional designs of future products, such as foldable mobile phones, ring mobile phones, heterogeneously curved terminal products, and the like. The arrival of 5G enables all smart products to be electrically connected and the acceleration of the data transmission enables some modules of smart terminal products, such as camera modules, BOX acoustic modules, and the like, to be separated from smart terminal products and to achieve their functions. With a further development of battery technology, the size of the terminal product is smaller, the battery capacity is higher, and the design form of the terminal product is more flexible.

With increasing requirements for flexible screen products, when dealing with different tasks such as watching videos and making phone calls, the display area needs to be enlarged or reduced to improve user experience. Currently, there are mainly two screen expansion structures: the foldable screen structure and the retractable screen structure.

CN 209120296 U relates to a camera assembly and electronic equipment. The camera module can comprise a camera assembly, and the camera assembly and a shell of electronic equipment to which the camera module belongs can slide relatively; the driving assembly is used for driving the camera assembly to slide relative to the shell and comprises a driving main body and a lead screw structure, and the driving main body comprises a power output shaft; the lead screw structure and the driving main body are arranged in parallel, and the lead screw structure is connected with the camera assembly; one end of the transmission structure is connected with the power output shaft, the other end of the transmission structure is connected with the lead screw structure, and the motion transmission direction of the transmission structure is parallel to the side-by-side direction of the driving main body and the lead screw structure; and when the power output shaft rotates, the transmission structure acts on the lead screw structure, so that the lead screw structure translates and drives the camera assembly to slide relative to the shell.

CN 112153180 A provides a display screen telescopic mechanism and a mobile terminal, and relates to the technical field of communication equipment. The display screen is a flexible display screen, the flexible display screen is provided with a first side edge and a second side edge which are opposite, the display screen telescopic mechanism comprises a mounting plate, and the mounting plate is provided with a first mounting surface and a second mounting surface which are opposite; the first mounting surface is used for fixing the first side edge, the second side edge can bypass the outer edge of the mounting plate to be slidably arranged on the second mounting surface, the sliding direction of the second side edge is parallel to the first direction, and the first direction is parallel to the second mounting surface and perpendicular to the second side edge; the display screen telescopic mechanism further comprises a driving structure which is used for driving the second side edge to move in the first direction.

In US 2020267246 A1, a mobile terminal is disclosed including a first frame, a second frame slidable with respect to the first frame between a first position and a second position, a third frame at a rear side and configured to be slidable with respect to the second frame between a third position and a fourth position, a flexible display unit including a first area, a second area, and a third area, and a sliding unit configured to allow the second frame to slide between the first position and the second position and the third frame to slide between the third position and the fourth position, wherein an area of the third area visible from a front side increases as the second frame slides from the first position to the second position and the third frame slides from the third position to the fourth position.

US 2020267247 A1 relates to a mobile terminal having a flexible display unit. The present disclosure provides a mobile terminal including a first frame, a second frame coupled to the first frame movably and configured to move in a first direction against the first frame, a third frame coupled to the second frame movably and configured to move in the first direction against the second frame, a flexible display unit including a first region disposed on a front side of the mobile terminal and coupled to the first frame, a second region disposed on a backside of the mobile terminal and coupled to the third frame, and a third region elongated between the first and second regions, wherein the third region is disposed on the front side or backside of the mobile terminal selectively according to a moving direction of the second frame by being rolled around the second frame, and a drive unit configured to move the second frame in the first direction against the first frame and move the third frame in the first direction against the second frame.

CN 112866451 A relates to electronic device and a driving mechanism. The electronic device comprises a shell assembly, a flexible display module and a driver, wherein the shell assembly comprises a first shell and a second shell, and the first shell is provided with a first end part. The flexible display module comprises a fixed part and a free part, the fixed part is connected with the first shell, the free part bypasses one end, far away from the first shell, of the second shell and extends into the shell assembly, and the free part is provided with a second end part. The driver is arranged at the first end part and used for driving the second shell to move relative to the first shell so that the flexible display module can be switched between the unfolded state and the folded state. In the unfolded state, the free part is unfolded on the second shell. The unfolded free part is retracted into the shell assembly in the folded state, and in the moving direction of the second shell relative to the first shell, the maximum thickness position in the thickness direction of the electronic equipment of the driver is located between the first end part and the second end part.

### SUMMARY

The present invention relates to the technical field of retractable screen products, and more particularly to an electronic device having a driving mechanism.

The present invention provides an electronic device having a driving mechanism to solve at least part of the problems in the related art.

The electronic device is set out in the appended set of claims.

According to a first aspect, the present invention provides a driving mechanism for a retractable screen structure. The driving mechanism includes a frame body, as well as a driving assembly and a transmission assembly mounted on the frame body;
the driving assembly includes a driving member and a reduction gearbox structure connected to the driving member, both the driving member and the reduction gearbox structure being mounted to the frame body;
the transmission assembly includes a first transmission member and a second transmission member movably connected to the first transmission member, the first transmission member being mounted to the frame body and connected to the reduction gearbox structure, the second transmission member being configured to be in transmission connection with a flexible display screen of the retractable screen structure;
the driving member outputting a first torque to the reduction gearbox structure, the reduction gearbox structure converting the first torque into a second torque and outputting the second torque to the first transmission member to drive the first transmission member to rotate, the second transmission member moving relative to the first transmission member to drive the flexible display screen to move, wherein the first torque is less than the second torque.

Optionally, the first transmission member is a lead screw, the second transmission member is a nut in threaded fit with the lead screw, and two ends of the lead screw are connected to the frame body through bearings.

Optionally, the driving mechanism further includes a guide rod arranged on the frame body, the guide rod being arranged in parallel with the lead screw;
the nut including a first sleeve portion and a second sleeve portion, the first sleeve portion being in threaded connection with the lead screw, the second sleeve portion being fitted over the guide rod.

Optionally, the driving member includes an output shaft, and the reduction gearbox structure includes a first reduction gearbox and a second reduction gearbox;
the first reduction gearbox includes a first gear, the second reduction gearbox includes a second gear and a third gear engaged with the second gear, the third gear is connected with the first transmission member, the second gear is engaged with the first gear, and the first gear is connected with the output shaft;
the output shaft outputs a first torque to the first gear, and the first torque is converted into a second torque, by the second gear and the third gear, to be output to the first transmission member.

Optionally, the reduction gearbox structure further includes a reduction gearbox end cover fixedly connected to a side of the frame body;
the first gear and the second gear are both connected to the reduction gearbox end cover, and the third gear is connected to the reduction gearbox end cover through the first transmission member.

Optionally, the first reduction gearbox includes a first bushing fixed to the reduction gearbox end cover, and the first gear is mounted to the first bushing.

Optionally, the second reduction gearbox includes a limit post fixed to the reduction gearbox end cover, and the second gear is mounted to the limit post.

Optionally, the first transmission member is a lead screw, an end of the lead screw is connected to the reduction gearbox end cover through a bearing, and the third gear is engaged with the lead screw.

Optionally, the first reduction gearbox further includes:
a fixed gear ring connected to the driving member, the output shaft extending into the fixed gear ring;
a driving gear mounted in the fixed gear ring and fixed to the output shaft;
a planetary gear carrier mounted in the fixed gear ring and engaged with and fixed to the first gear; and
a planetary gear mounted on the planetary gear carrier and engaged with the driving gear;
the output shaft outputting a first torque to the driving gear, the first torque being transmitted to the second gear by the driving gear, the planetary gear, and the planetary gear carrier.

Optionally, the reduction gearbox end cover is defined with a first through hole, the first bushing is fixed in the first through hole, and the first gear is a sun gear and is mounted to the first bushing.

Optionally, the reduction gearbox end cover is further defined with a second through hole, a second bearing is mounted inside the second through hole, and a second end of the lead screw is mounted to the second bearing to be fixed on the frame body.

According to a second aspect the present invention provides an electronic device, including:
a housing including a first housing and a second housing slidably arranged on the first housing along a first direction, the first housing and the second housing being enclosed to form a receiving structure with an opening;
a retractable screen structure arranged in the receiving structure, the retractable screen structure including a bracket and a flexible display screen, a first end of the flexible display screen being connected to the bracket and located on a side close to bottom of the housing, a second end of the flexible display screen being connected to the first housing to cover the opening; and
the driving mechanism according to the first aspect of the present invention, arranged in the receiving structure, the driving mechanism being connected to the bracket and configured to drive the bracket to move along the first direction;
the driving mechanism driving the bracket to move along the first direction, so as to drive the second housing and the first end of the flexible display screen to move along the first direction relative to the first housing, such that the flexible display screen is switched between a retracted state and an expanded state.

According to the invention, the electronic device further includes a sliding rail assembly slidably arranged on the bracket along the first direction, the sliding rail assembly being connected to the first end of the flexible display screen;
when the flexible display screen moves along the first direction, the flexible display screen driving the sliding rail assembly to slide along the first direction relative to the bracket.

Optionally, the bracket of the retractable screen structure is provided with a third transmission member, and the second transmission member is further provided with a protrusion for abutting against the third transmission member of the bracket of the retractable screen structure.

Optionally, the electronic device comprises two driving mechanisms.

It is to be understood that both the foregoing general description and the following detailed description are exemplary and explanatory only and are not restrictive of the present invention, as claimed.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is an exploded view of a retractable screen structure according to an embodiment of the present invention;
Fig. 2 is an exploded schematic view of a sliding rail assembly of a sliding rail mechanism according to an embodiment of the present invention;
Fig. 3 is a structural view of a sliding rail mechanism according to an embodiment of the present invention;
Fig. 4 is a structural view of a sliding rail assembly of a sliding rail mechanism according to an embodiment of the present invention;
Fig. 5 is a sectional view illustrated in Fig. 4 along X1-X1 direction;
Fig. 6 is a partially enlarged view of a position A in Fig. 5;
Fig. 7 is a partially enlarged view of a position B in Fig. 5;
Fig. 8 is a partially enlarged view of a position C in Fig. 5;
Fig. 9 is a structural view of an elastic assembly of a sliding rail mechanism according to an embodiment of the present invention;
Fig. 10 is a structural view of a retractable screen structure according to an embodiment of the present invention;
Fig. 11 is a structural view of a rotating shaft assembly of a retractable screen structure according to an embodiment of the present invention;
Fig. 12 is an enlarged view of position A in Fig. 11;
Fig. 13 is a structural view of a rotating shaft assembly of a retractable screen structure according to another embodiment of the present invention;
Figs. 14 and 15 are schematic views of an electronic device according to an embodiment of the present invention when a flexible display screen is in a retracted state and an expanded state, respectively;
Fig. 16 shows contrast views of an electronic device according to an embodiment of the present invention when a flexible display screen is in a retracted state and an expanded state, respectively;
Fig. 17 is a perspective view of a driving mechanism of an electronic device according to an embodiment of the present invention;
Fig. 18 is an exploded view of a driving mechanism of an electronic device according to an embodiment of the present invention;
Fig. 19 is an exploded view of a first reduction gearbox of a driving mechanism of an electronic device according to an embodiment of the present invention; and
Fig. 20 is a schematic view illustrating a mounting position of a driving mechanism of an electronic device according to an embodiment of the present invention.

### DETAILED DESCRIPTION

Embodiments of the present disclosure will be described in details herein, and the examples thereof are illustrated in the accompanying drawings. When the description below concerns the drawings, same numbers in different drawings represent same or similar elements unless indicated otherwise. In the following embodiments, the embodiments illustrated do not represent all embodiments consistent with the present disclosure. Instead, they are merely examples of devices and methods consistent with some aspects of the present disclosure as detailed in the appended claims.

The terms used in the present disclosure are merely for the purpose of describing specific embodiments, which are not intended to limit the present disclosure. Unless defined otherwise, the technical or scientific terminologies used in the present disclosure shall be the general meaning understood by those skilled in the related art of the present disclosure. Terms such as "first", "second" and the like used in the descriptions and claims of the present disclosure do not indicate any order, quantity or importance, but are only used to distinguish different components. Similarly, terms such as "one" or "a" do not refer to quantity limitation, but to indicate the existence of at least one. Similarly, terms such as "one" or "a" do not refer to quantity limitation, but to indicate the existence of at least one. "a plurality" or "several" means two and more than two. Unless specified otherwise, terms such as "front portion", "rear portion", "lower portion" and/or "upper portion", and the like are merely for convenience of description, and are not limited to one position or one spatial orientation. Terms such as "comprise" or "comprising" and the like mean that the elements or objects presented before "comprise" or "comprising" contain the elements or objects presented after "comprise" or "comprising" and their equivalents, which do not exclude other elements or objects. The terms "mounted," "connected," and the like are not restricted to physical or mechanical connections, can also be electrical connections, no matter direct or indirect.

The terms used in the present disclosure are merely for the purpose of describing specific embodiments, which are not intended to limit the present disclosure. As used in the descriptions and the appended claims of the present disclosure, "a" and "the" in singular forms mean including plural forms, unless clearly indicated in the context otherwise. It should also be understood that, as used herein, the term "and/or" represents and contains any and all possible combinations of one or more associated listed items.

The present invention provides a driving mechanism and an electronic device. A sliding rail mechanism, a retractable structure and the electronic device of the present invention will be described in detail below with reference to the accompanying drawings. In the case of no conflict, the features in the following embodiments and implementations may be combined with each other.

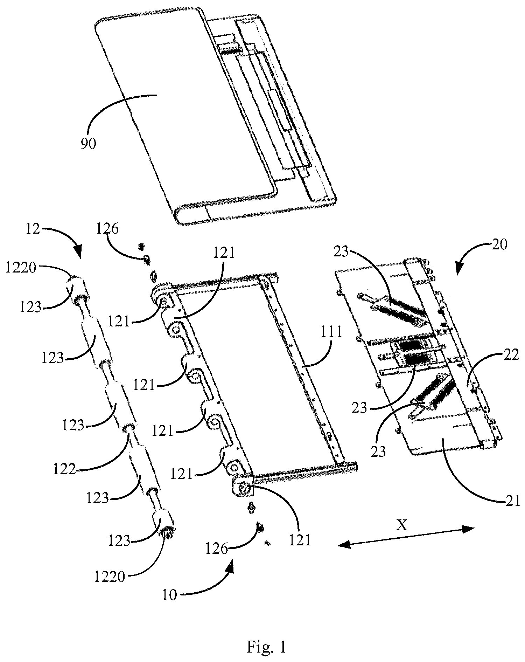

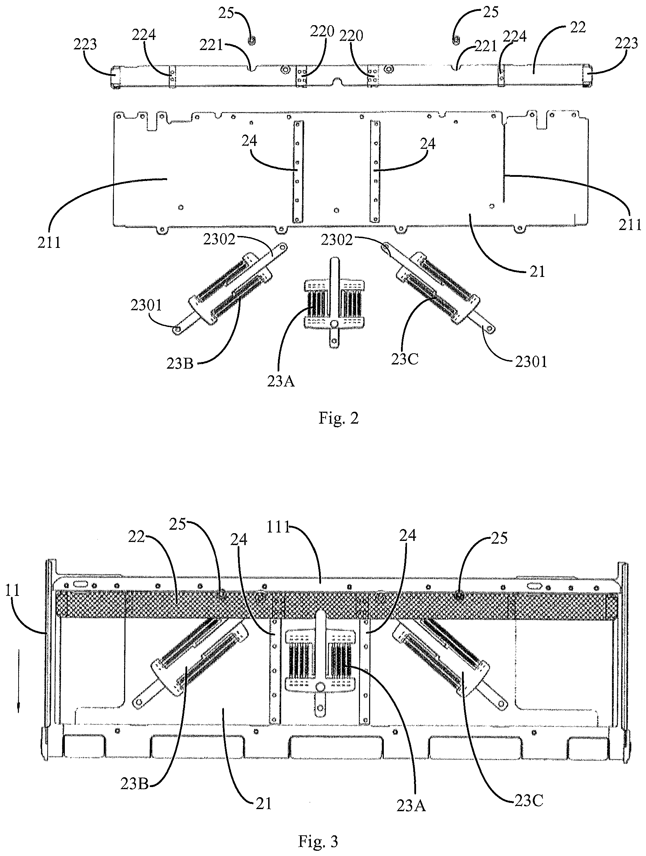

Referring to Figs. 1 to 3, an embodiment of the present invention provides an electronic device, including: a bracket assembly 10, a rotating shaft assembly 12, a flexible display screen 90, and a sliding rail assembly 20. The bracket assembly 10 includes a bracket 11. The sliding rail assembly 20 includes a fixed base 21, a sliding member 22 configured to connect the flexible display screen 90 of a retractable screen structure, and an elastic assembly 23. The fixed base 21 is fixedly connected to the bracket 11, the sliding member 22 is slidingly arranged on the fixed base 21 along a first direction X (a vertical direction illustrated in Fig. 3), a first end 2301 of the elastic assembly 23 is connected to the fixed base 21, and a second end 2302 of the elastic assembly 23 is connected to the sliding member 22. When sliding relative to the fixed base 21 along the first direction X, the sliding member 22 drives the second end of the elastic assembly 23 and the flexible display screen 90 to move together. The elastic assembly 23 is stretched or compressed under the drive of the sliding member 22 to deform, thereby generating a pre-tension to the flexible display screen 90. It can be understood that the sliding member 22 slides relative to the fixed base 21 along a direction indicated by an arrow in Fig. 3, and then stretches the elastic assembly 23 to generate a reverse tension force.

In the sliding rail mechanism with the above arrangement, the sliding member 22 moves along the first direction X relative to the fixed base 21, and then enables to drive the flexible display screen 90 of the retractable screen structure to move together, thereby realizing the expanding and retracting of the flexible display screen 90. The sliding member 22 drives the elastic member 23 to move together so as to stretch the elastic member 23, thereby generating a pre-tension on the flexible display screen 90. Thus, the flexible display screen 90 becomes much flatter when expanded, thereby preventing visual problems such as bulging, swelling and distortion of the screen when the whole device is slid open.

Optionally, the sliding rail assembly 20 further includes at least one guide rail 24 arranged on the fixed base 21 and extending along the first direction X, the sliding member 22 is defined with a sliding groove 220 corresponding to the guide rail 24, and the sliding member 22 is slidably arranged on the guide rail 24 through the sliding groove 220. In the present embodiment, four sets of guide rails 24 are provided and symmetrically arranged on the fixed base 21, such that the sliding member 22 may slide more stably. In other examples, there may also be other numbers of guide rails 24, which is not limited in the present disclosure.

Optionally, the sliding rail assembly 20 further includes at least one limit stopper 25, arranged at an end of the fixed base 21 away from the bracket 11 (i.e., an upper end in Fig. 3). The sliding member 22 is provided with a limit portion 221 abutting against and cooperating with the limit stopper 25. The limit stopper 25 abuts against and cooperates with the limit portion 221 of the sliding member 22 to limit a starting position of the sliding member 22 and also prevent the sliding member 22 from separating from the guide rail 24. In the present embodiment, the limit portion 221 may be understood as a groove, two limit stoppers 25 are provided and symmetrically arranged on the fixed base 21, two limit portions 221 are provided and correspond to the limit stoppers 25, which is not limited in the present disclosure. In the example illustrated in Fig. 3, the limit stoppers 25 are arranged at an upper end of the fixed base 21, and a starting position of the sliding member 22 is located at the upper end of the fixed base 21. In this state, the elastic assembly 23 applies an elastic pre-tension to the sliding member 22 so as to keep the sliding member 22 at the starting position.

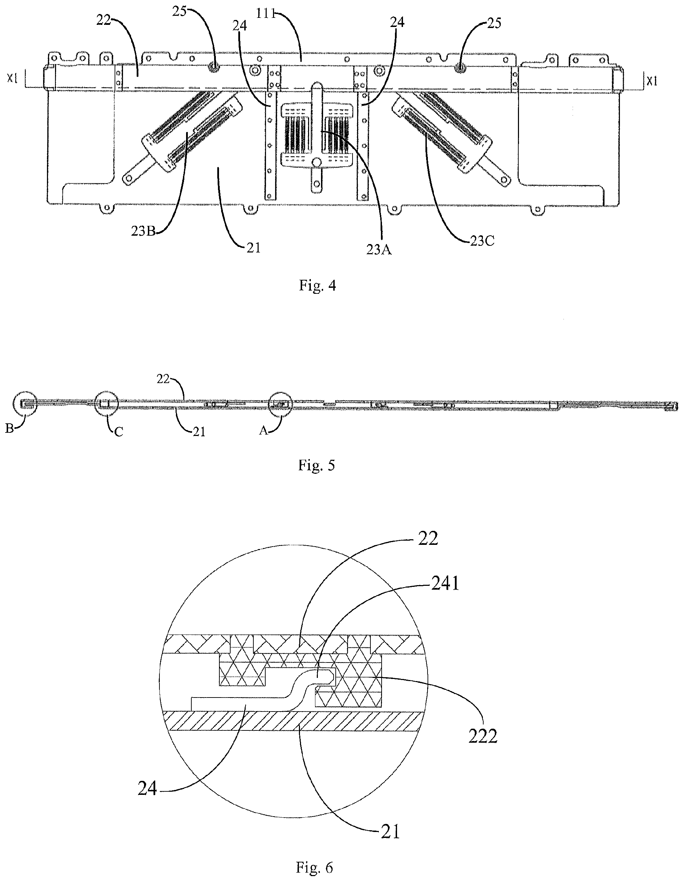

Referring to Figs. 4 to 6, optionally, at least one side of the guide rail 24 is provided with a clamping portion 241, and the sliding member 22 is provided with a first snap portion 222 snapped with the clamping portion 241. The sliding member 22 is snapped with the clamping portion 241 of the guide rail 24 through the first snap portion 222 so as to be more securely connected to the guide rail 24, such that the sliding member 22 may more stably slide along the guide rail 24. It may be understood that the clamping portion 241 may be an inverted hook structure machined from a sheet metal part to prevent the sliding member 22 from moving away from the guide rail 24. In the present embodiment, two sides of the guide rail 24 are each provided with the clamping portion 241, which is not limited in the present disclosure.

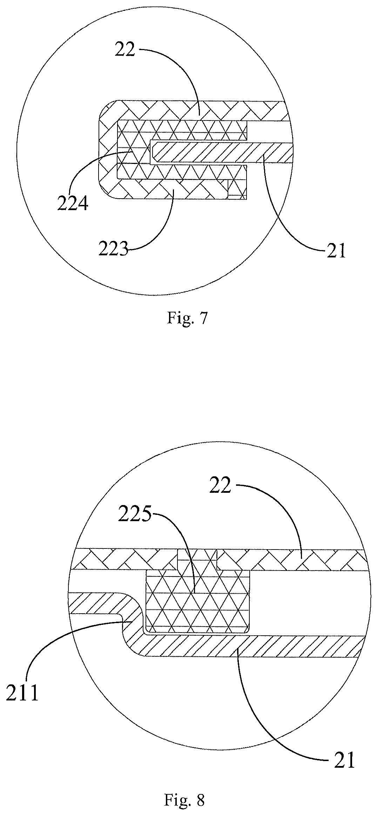

Referring to Fig. 7, optionally, the side of the sliding member 22 is provided with a second snap portion 223 snapped with a side of the fixed base 21. The sliding member 22 is snapped with the side of the fixed base 21 through the second snap portion 223, such that the sliding member 22 and the fixed base 21 are connected more stably and the sliding member 22 is prevented from separating from the fixed base 21 when sliding, thus improving the sliding stability of the sliding member 22. Further, the sliding rail assembly 20 further includes a plastic snap 224, covering and snapped at the side of the fixed base 21, and the second snap portion 223 is snapped to the plastic snap 224. The plastic snap 224 enables to reduce friction between the second snap portion 223 and the side of the fixed base 21, reduce wear and ensure smooth sliding. In the present embodiment, the plastic snap 224 may be made of POM (Polyoxymethylene) plastic which is a self-lubricating plastic. The sliding member 22 and the plastic snap 224 may be combined as one part through an insert-molding process. A design gap between the plastic snap 224 and the side of the fixed base 21 may be 0.05 mm to ensure that the sliding member 22 may only slide along an extending direction of the guide rail 24, i.e., the first direction X, thus improving the structural stability.

Referring to Fig. 8, optionally, the fixed base 21 is provided with a step portion 211 extending along the first direction X, and the sliding member 22 is provided with an abutting block 225 abutting against the step portion 211. Through cooperation between the abutting block 225 and the step portion 211, the sliding member 22 may be further prevented from separating from the fixed base 21 when sliding.

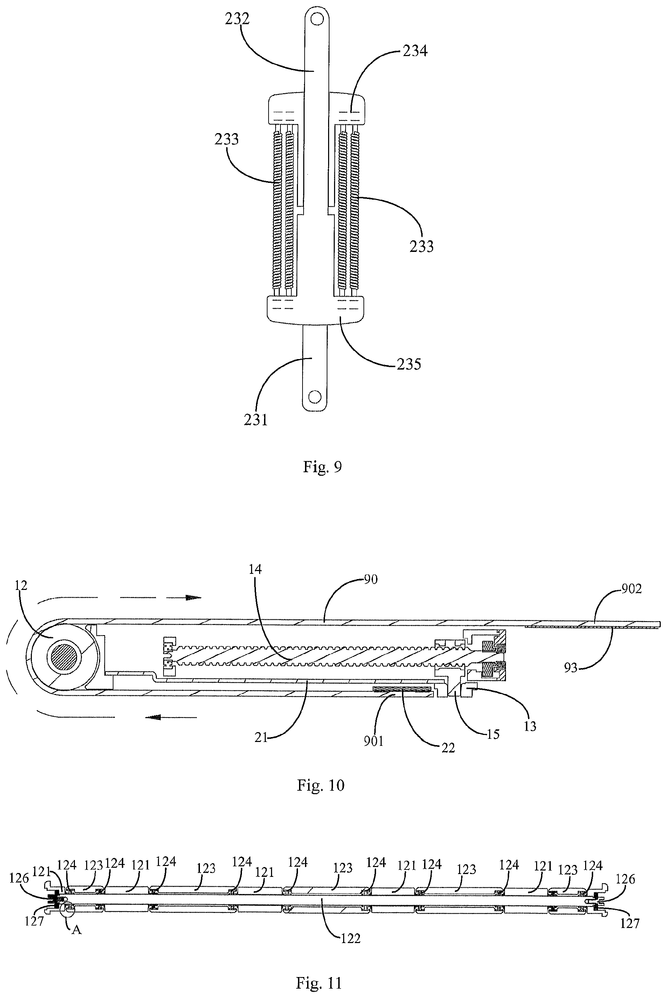

Referring to Fig. 9, optionally, the elastic assembly 23 includes a first rod 231, a second rod 232, and elastic members 233. The first rod 231 and the second rod 232 are inserted into each other and slidable relative to each other, and the elastic member 233 is connected between the first rod 231 and the second rod 232. The first rod 231 is connected to the fixed base 21, and the second rod 232 is connected to the sliding member 22. The elastic member 233 may be a spring, a tension spring, or the like, and has a pre-tension during assembly to keep the sliding member 22 at the starting position. When the first rod 231 and the second rod 232 are stretched, the spring starts to work. When sliding relative to the fixed base 21, the sliding member 22 drives the second rod 232 to slide relative to the first rod 231 and cooperates with the first rod 231 to stretch or compress the elastic member 233, such that the elastic member 233 is deformed to generate an elastic force to the sliding member 22.

Further, the first rod 231 and the second rod 232 are each defined with a sliding groove, and the first rod 231 and the second rod 232 are inserted into each other and slidable relative to each other. A first end (a lower end illustrated in Fig. 9) of the first rod 231 is fixed to the fixed base 21 by a rivet, and a first end (an upper end illustrated in Fig. 9) of the second rod 232 is fixed to the sliding member 22 by a rivet, a second end of the first rod 231 protrudes outward to form a first protrusion 234, and a second end of the second rod 232 protrudes outward to form a second protrusion 235; there are a plurality sets of the elastic members 233 evenly arranged between the first protrusion 234 and the second protrusion 235, which may provide sufficient elastic force. When sliding relative to the fixed base 21, the sliding member 22 drives the second rod 232 to slide relative to the first rod 231 and cooperates with the first rod 231 to stretch the elastic member 233, such that the elastic member 233 is deformed to generate a reverse tension on the sliding member 22, thus ensuring that the flexible display screen is in a "tightened" state.

Optionally, there are a plurality of the elastic assemblies 23, including a first elastic assembly 23A, a second elastic assembly 23B, and a third elastic assembly 23C. The second elastic assembly 23B and the third elastic assembly 23C are symmetrically arranged on two sides of the first elastic assembly 23A. The elastic member 233 of the first elastic assembly 23A extends along the first direction X, and the elastic members 233 of the second elastic assembly 23B and the third elastic assembly 23C are symmetrically arranged along the first direction X and inclined with respect to the first direction X.

Due to limited space, it is difficult for a single guide rail to achieve such a large elastic stroke. Based on the above arrangement, the three sets of elastic assemblies may form a relay form to improve the sliding stroke of the elastic assemblies. The second elastic assembly 23B and the third elastic assembly 23C are in the same design and are arranged symmetrically on two sides of the elastic assembly 23A. An initial compression amount of the elastic member of the first elastic assembly 23A may be slightly greater than the initial compression amounts of the elastic members of the second elastic assembly 23B and the third elastic assembly 23C, thereby achieving a greater sliding stroke. Assuming that the designed total sliding stroke is 30.00 mm, the first elastic assembly 23A may start working after the sliding member 22 slides by 19 mm.

In some possible embodiments, the sliding rail assembly 20 may be fixed to the bracket 11 as a whole by riveting. An end of the bracket 11 may include a connecting plate 111, and the fixed base 21 may be a stamped metal plate and fixed to the connecting plate 111 through a riveting process. The flexible display screen 90 is fixed to the sliding member 22 of the sliding rail assembly 20. The bracket 11 may be made of an aluminum alloy to improve the structural strength. The sliding member 22 may be machined from a SUS stainless steel plate and a POM plastic by the insert-molding process. The stainless steel plate may serve as a body to play the role of strength support. The sliding groove may be made of the POM plastic by insert-molding and may slide relative to the fixed base 21 and the guide rail 24 to reduce friction. The limit stopper 25 may be made of a plastic material and may limit the starting position of the sliding member 22 and also prevent the sliding member 22 from separating from the guide rail 24. The guide rail 24 may be machined from stainless steel by a stamping process and fixed to the fixed base 21 by spot welding. The guide rail 24 cooperates with the sliding groove 220 in the sliding member 22 to form an inverted hook structure to prevent the sliding member 22 from moving away from the guide rail 24 when sliding. An exposed surface of the sliding member 22 may serve as an adhesive area 226 to be adhered and fixed to the flexible display screen 90.

Referring to Figs. 1 and 10, an embodiment of the present invention provides a retractable screen structure, including the sliding rail mechanism and the flexible display screen 90 described in the above embodiments. The rotating shaft assembly 12 is arranged on a side of the bracket 11 away from the sliding rail assembly 20, and an axial direction of the rotating shaft assembly 12 is perpendicular to the first direction X. A first end of the flexible display screen 90 is connected to the sliding member 22, and a second end of the flexible display screen 90 is wound on the rotating shaft assembly 12.

The rotating shaft assembly 12 includes a rotating shaft support, a rotating shaft 122, and a rotating wheel. The rotating shaft support is connected to a side of the bracket 11 away from the sliding rail assembly 20 and is defined with a shaft hole, and a circumferential direction of the shaft hole is perpendicular to the first direction X. The rotating shaft 122 passes through the shaft hole, and the rotating wheel is fitted over the rotating shaft 122. The flexible display screen 90 is wound on the rotating wheel, and when the flexible display screen 90 is expanded or retracted, the rotating wheel is driven to rotate. It may be understood that the first end 901 of the flexible display screen 90 is connected to the sliding member 22 of the sliding rail assembly 20, and the second end 902 of the flexible display screen 90 is wound on the rotating wheel. In the present embodiment, the flexible display screen 90 is formed by bonding a flexible OLED screen and a layer of extremely thin stainless steel mesh together and has great flexibility.

Based on the above arrangement, the flexible display screen 90 is wound on the rotating wheel of the rotating shaft assembly 12. When the flexible display screen 90 is expanded or retracted, the rotating wheel is driven to rotate, that is, the rotating wheel rotates passively. The rotating wheel may function as a pulley such that the flexible display screen 90 may be expanded and retracted more smoothly, which effectively reduces the friction and energy loss during the expanding and retracting process of the flexible display screen 90, thereby enabling the flexible display 90 to be expanded or retracted more smoothly.

Optionally, the rotating shaft 122 is fixedly connected to the shaft hole, and the rotating wheel is rotatably connected to the rotating shaft 122. It may be understood that the rotating shaft 122 is fixedly connected to the rotating shaft support, the rotating wheel is rotatable relative to the rotating shaft 122, and the rotating shaft does not rotate relative to the rotating shaft support. When the flexible display screen 90 is expanded or retracted, only the rotating wheel is driven to rotate.

Referring to Figs. 1 and 11, optionally, the rotating shaft support includes a plurality of sub-supports 121, which are arranged on the bracket 11 along a direction perpendicular to the first direction X and spaced apart from each other. Each sub-support 121 is defined with a sub-shaft hole; the sub-shaft holes of the plurality of sub-supports 121 are coaxially arranged to define the shaft hole, and the rotating shaft 122 passes through the plurality of sub-shaft holes so as to be fixedly connected with the plurality of sub-supports 121. The rotating shaft includes a plurality of sub-rotating wheels 123, and one of the plurality of sub-rotating wheels 123 is arranged between two adjacent sub-supports 121. It may be understood that the rotating shaft support is configured as the plurality of sub-supports 121, the rotating wheel is configured as the plurality of sub-rotating wheels 123, and the sub-supports 121 and the sub-rotating wheels 123 are arranged alternately, which may ensure the rotation performance of the rotating wheel, enhance the strength of the rotating shaft support, and improve the overall structural strength. It may be understood that each of the sub-supports 121 of the rotating shaft support is fixedly connected to the bracket 11, or may also be integrally formed with the bracket 11. It should be noted that all the sub-supports 121 may be different in size, for example, may be divided into small supports and large supports, and the sub-supports located on both sides is small supports, and the sub-support located at middle position is a large support. All the sub-rotating wheels 123 may also be different in size, for example, may be divided into large rotating wheels and small rotating wheels, which may be arranged according to actual needs and will not be limited in the present disclosure.

Optionally, the rotating shaft assembly 12 further includes a plurality of first bearings 124 fitted over the rotating shaft 122, and each of two sides of the sub-rotating wheel 123 is provided with one first bearing 124. The first bearing 124 includes an inner bearing ring and an outer bearing ring rotatably connected to the inner bearing ring, the inner bearing ring is connected to the rotating shaft 122, and the outer bearing ring is connected to the sub-rotating wheel 123. It may be understood that the sub-rotating wheel 123 rotates relative to the rotating shaft 122 through the first bearing 124, and the first bearing 124 may reduce the friction loss caused by the rotation of the sub-rotating wheel 123. The inner bearing ring and the rotating shaft 122 may have a zero-match design in a radial direction to ensure that the inner bearing ring cannot rotate together with the sub-rotating wheel 123. The sub-rotating wheel 123 and the rotating shaft 122 may have an avoidance design in the radial direction to ensure that a gap is defined between the sub-rotating wheel 123 and the rotating shaft 122 to achieve rotation.

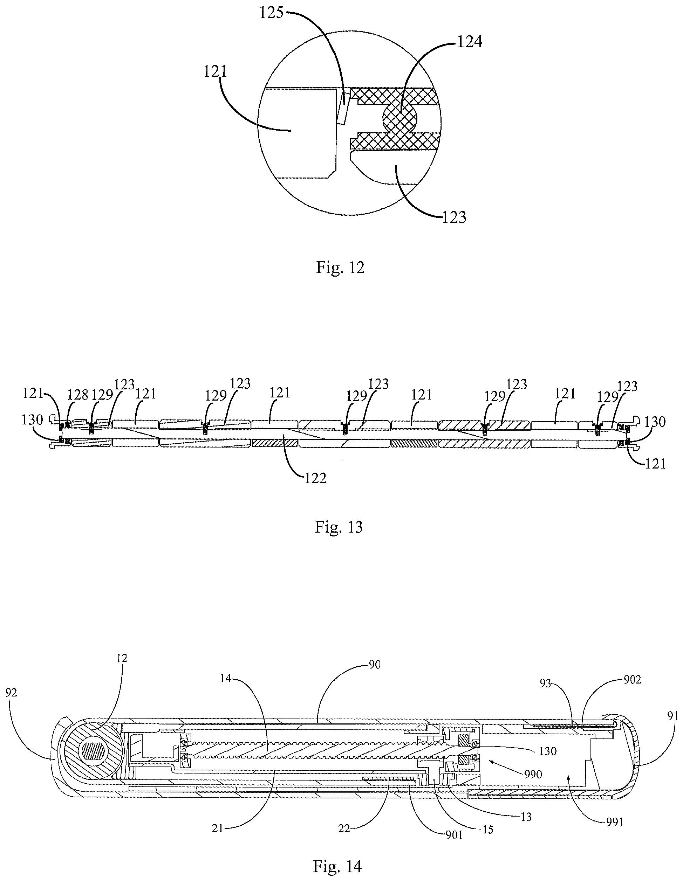

Referring to Fig. 12, in order to prevent the inner bearing ring from rotating together with the sub-rotating wheel 123, that is, to ensure that the inner bearing ring does not rotate relative to the rotating shaft 122, the rotating shaft assembly 12 further includes a plurality of bearing spacers 125 fitted over the rotating shaft 122, and a side of each first bearing 124 is provided with a bearing spacer 125. One end of the bearing spacer 125 abuts against the inner bearing ring, and the other end of the bearing spacer 125 abuts against the adjacent sub-support 121. In this way, the inner bearing ring and the adjacent sub-support 121 may be pressed against each other to prevent the inner bearing ring from rotating together with the sub-rotating wheel 123, thus ensuring that the inner bearing ring does not rotate relative to the rotating shaft 122. In this way, the rotation of the sub-rotating wheel 123 completely relies on the rotation of the outer bearing ring and the friction loss is relatively low.

Optionally, the bearing spacer 125 is made of copper or stainless steel, with a bowl-like cross section, and has a mechanical property that is slightly compressible in a thickness direction. A bottom end of the bowl-like structure abuts against the inner bearing ring, and a bowl opening end of the bowl-like structure abuts against the adjacent sub-support 121, such that the inner bearing ring and the adjacent sub-support 121 are pressed against each other.

Optionally, the rotating shaft assembly 12 further includes two sets of first fasteners 126. One end of the rotating shaft 122 is fixedly connected to the rotating shaft support through one set of the first fasteners 126, and the other end of the rotating shaft 122 is fixedly connected to the rotating shaft support through the other set of the first fasteners 126. It may be understood that the first fasteners 126 pass through the outermost sub-support 121 and are fixedly connected to the ends of the rotating shaft 122, so as to fix the rotating shaft 122 and the rotating shaft support together. Optionally, a gasket 127 is further provided between the first fastener 126 and the rotating shaft support. The first fastener 126 may be a dual screw, and the gasket 127 is provided between the first fastener 126 and the outermost sub-support 121 such that the rotating shaft 122 and the rotating shaft support may be connected more firmly. Further, a gap between the sub-support 121 and the inner bearing ring may be set to zero match or slight interference (depending on the material and the sizes of the parts). Thus, a pressure exists between the bearing spacer 125 and the inner bearing ring through the locking force of the dual screws arranged at the two ends, and this pressure may ensure that the inner bearing ring does not rotate relative to the rotating shaft 122.

In the present embodiment, the sub-rotating wheel 123 may be made of the engineering plastic POM by insert-molding and is defined with a through hole in the middle and grooves at two ends to place the first bearings 124, the sub-rotating wheel 123 is fitted over the rotating shaft 122, and may be rotated passively on the rotating shaft 122 by the first bearings 124 after assembly. The rotating shaft 122 may be a D-shaped shaft with a D-shaped cross section, and is mainly configured to fix the inner bearing ring, thereby preventing the inner bearing ring from rotating relative to the rotating shaft. The rotating shaft 122 may be made of stainless steel, and the rotating shaft 122 passes through the plurality of sub-supports 121. Threads 1220 may be formed at two ends of the rotating shaft 122 to achieve fastening connection with the first fasteners126 and to be easily fixed to a middle frame of the electronic device, thereby fixing the rotating shaft. The first fastener 126 may be made of metal material, such as a dual screw. The first fastener 126 passes through the gasket 127 and is locked on the rotating shaft 122 to lock the rotating shaft 122 and the rotating shaft support. The material of the first bearing 124 may be stainless steel or ceramic, and the first bearing 124 is mounted on the sub-rotating wheel 123. Two ends of each sub-rotating wheel 123 are each mounted with one first bearing 124 and also mounted with the bearing spacer 125. The bearing spacer 125 may be made of a metal. During mounting of the sub-rotating wheels on the rotating shaft, each of two sides of each rotating wheel is placed with one bearing spacer, and the rotating shaft passes through the inner holes of the bearing spacers. After the two ends of the rotating shaft are locked by the dual screws, the gasket functions to fix the inner bearing ring to prevent the inner bearing ring from rotating with the outer bearing ring, and the gasket further functions to ground the first bearing and the bracket.

Referring to Figs. 1 and 13, optionally, the rotating shaft 122 is rotatably connected with the shaft hole, and the rotating wheel is fixedly connected with the rotating shaft 122. It may be understood that the rotating shaft 122 is fixedly connected to the rotating wheel, the rotating wheel does not rotate relative to the rotating shaft 122, and the rotating shaft 122 is rotatable relative to the rotating shaft support. When the flexible display screen 90 is expanded or retracted, the flexible display screen 90 drives the rotating wheel and the rotating shaft 122 to rotate together.

Optionally, the rotating shaft support includes a plurality of sub-supports 121, which are arranged on the bracket 11 along a direction perpendicular to the first direction X and spaced apart from each other. Each sub-support 121 is defined with a sub-shaft hole; the sub-shaft holes of the plurality of sub-supports 121 are coaxially arranged to define the shaft hole, and the rotating shaft 122 passes through the plurality of sub-shaft holes so as to be fixedly connected with the plurality of sub-supports 121. The rotating shaft includes a plurality of sub-rotating wheels 123, and one of the plurality of sub-rotating wheels 123 is arranged between two adjacent sub-supports 121. It may be understood that the rotating shaft support is configured as the plurality of sub-supports 121, the rotating wheel is configured as the plurality of sub-rotating wheels 123, and the sub-supports 121 and the sub-rotating wheels 123 are arranged alternately, which may ensure the rotation performance of the rotating wheel, enhance the strength of the rotating shaft support, and improve the overall structural strength. It may be understood that each of the sub-supports 121 of the rotating shaft support is fixedly connected to the bracket 11, or may also be integrally formed with the bracket 11. It should be noted that all the sub-supports 121 may be different in size, for example, may be divided into small supports and large supports, and the sub-supports located on both sides is small supports, and the sub-support located at middle position is a large support. All the sub-rotating wheels 123 may also be different in size, for example, may be divided into large rotating wheels and small rotating wheels, which may be arranged according to actual needs and will not be limited in the present disclosure.

Optionally, the rotating shaft assembly 12 further includes two second bearings 128 which are respectively fitted over two ends of the rotating shaft 122, and the ends of the rotating shaft 122 are rotatably connected with the rotating shaft support through the second bearings 128. The second bearing 128 includes an inner bearing ring and an outer bearing ring rotatably connected to the inner bearing ring, the inner bearing ring is connected to the rotating shaft support, and the outer bearing ring is connected to the rotating shaft 122. It may be understood that the rotating shaft 122 rotates relative to the sub-support 121 of the rotating shaft support through the second bearing 128, and the second bearing 128 may reduce the friction loss caused by the rotation of the rotating shaft 122. The sub-rotating wheel 123 and the rotating shaft 122 may have a zero-match design in the radial direction to ensure that the sub-rotating wheel 123 rotates with the rotating shaft 122. The sub-support 121 of the rotating shaft support and the rotating shaft 122 may have an avoidance design in the radial direction to ensure that a gap is defined between the sub-rotating wheel 123 and the rotating shaft 122 to achieve rotation. In the present embodiment, only two second bearings 128 are required to achieve the rotation of the rotating shaft 122 relative to the rotating shaft support, which reduces the number of bearings and simplifies the model design.

Optionally, the rotating shaft assembly 12 further includes two shaft covers 130. One of the shaft covers 130 abuts against an inner ring of the adjacent rotating shaft 122 from one end of the shaft hole, and the other shaft cover 130 abuts against the inner ring of the adjacent rotating shaft 122 from the other end of the shaft hole. The inner bearing ring is pressed by the shaft covers 130 to limit the rotating shaft 122 in the axial direction, thereby preventing the rotating shaft 122 from being displaced in the axial direction.

Optionally, the rotating shaft assembly 12 further includes a plurality of second fasteners 129, and the second fasteners 129 pass through the sub-rotating wheels 123 and are fixedly connected with the rotating shaft 122. It may be understood that one sub-rotating wheel 123 may be fixedly connected to the rotating shaft 122 through one second fastener 129, or may also be fixedly connected to the rotating shaft 122 through the plurality of second fasteners 129, which is not limited in the present disclosure.

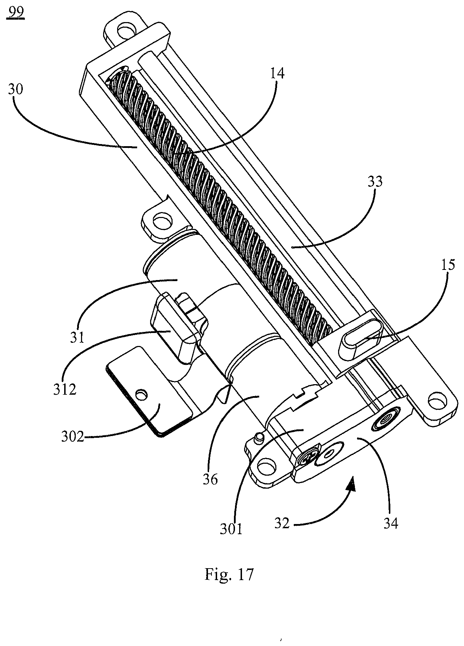

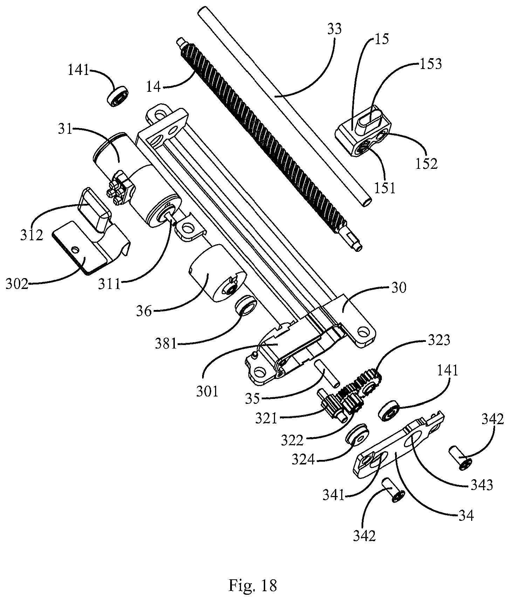

Referring to Figs. 17 to 20, an embodiment of the present invention provides an electronic device, which may be a mobile phone, a mobile terminal, a tablet computer, a laptop, a handheld terminal device with a screen, a vehicle-mounted display device, and the like. The electronic device includes a housing, a retractable screen structure as described in the above embodiments, and a driving mechanism 99.

The housing includes a first housing 91 and a second housing 92 slidably arranged on the first housing 91 along the first direction X, the first housing 91 and the second housing 92 are enclosed to form a receiving structure 991 with an opening. The retractable screen structure is arranged in the receiving structure 991, the rotating shaft assembly 12 is located on a side close to the second housing 92, a first end 901 of the flexible display screen 90 is located on a side close to bottom of the housing, and a second end 902 of the flexible display screen 90 is connected to the first housing 91 to cover the opening. The driving mechanism 99 is arranged in the receiving structure 991. The driving mechanism 99 is connected to the sliding rail mechanism and configured to drive the sliding rail mechanism to move along the first direction X. Optionally, the first housing 91 may be provided with a support plate 93, the second end of the flexible display screen 90 is connected to the support plate 93, and the support plate 93 may support and protect the flexible display screen 90.

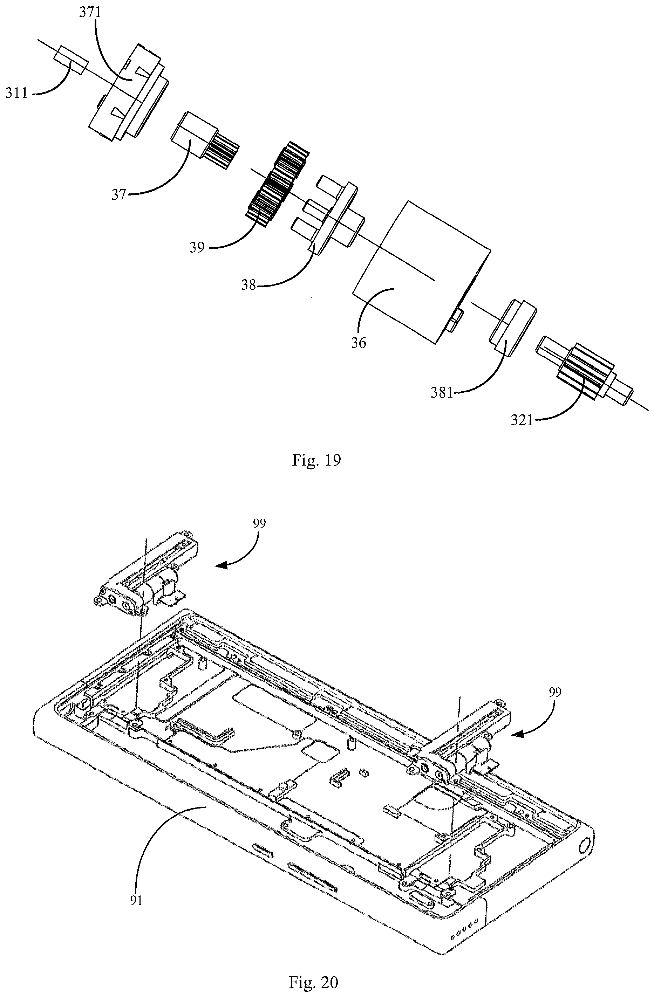

The driving mechanism 99 includes a frame body 30, a driving assembly and a transmission assembly mounted on the frame body 30. The frame body 30 may be provided with a mounting member 302 configured to be connected with the middle frame of the electronic device, and the mounting member 302 is fixed to the middle frame by a fastener, such that the driving mechanism 99 is mounted on the middle frame. Optionally, the number of driving mechanisms 99 may be set according to actual needs. In an example illustrated in Fig. 20, two driving mechanisms 99 are provided.

The driving assembly includes a driving member 31 and a reduction gearbox structure 32 connected to the driving member 31, and both the driving member 31 and the reduction gearbox structure 32 are mounted on the frame body 30. Optionally, the driving member 31 may be a driving motor or driving electric-machine.

The transmission assembly includes a first transmission member 14 and a second transmission member 15 movably connected to the first transmission member 14. The first transmission member 14 is mounted on the frame body 30 and connected to the reduction gearbox structure 32. The second transmission member 15 is configured to be in transmission connection with the flexible display screen of the retractable screen structure.

The driving member 31 outputs a first torque to the reduction gearbox structure 32, and the reduction gearbox structure 32 converts the first torque into a second torque and outputs the second torque to the first transmission member 14 to drive the first transmission member 14 to rotate, and the second transmission member 15 moves relative to the first transmission member 14 to drive the flexible display screen to move. The first torque is less than the second torque. It may be understood that the driving mechanism drives the sliding rail mechanism to move along the first direction X, so as to drive the second housing 92, the sliding rail assembly 20, the first end of the flexible display screen, and the sliding member 22 to move along the first direction X relative to the first housing 91, such that the flexible display screen 90 is switched between the expanded state and the retracted state.

Based on the above arrangement, the driving mechanism 99 converts the first torque output by the driving member into a higher second torque through the reduction gearbox structure, and then transmits the second torque to the first transmission member such that the first transmission member is then rotated, thereby driving the flexible display screen to move. In this way, a low torque of the driving member may be converted into a high torque to drive the first transmission member to rotate, so as to better drive the flexible display screen to move.

Optionally, the driving assembly may further include a control circuit board 312 connected to the driving member 31, which is configured to control the driving member 31 according to an instruction. The control circuit board 312 may be a FPC (Flexible Printed Circuit) board. The control circuit board 312 gets breakover with a terminal main board of the electronic device. When the flexible display screen needs to be expanded, the terminal main board transmits a command "expand" to the control circuit board 312. The control circuit board 312 controls the driving electric-machine to rotate, and the driving electric-machine amplifies the torque of the driving electric-machine through the reduction gearbox structure 32 and drives the second transmission member 15 to move linearly relative to the first transmission member 14. The second transmission member 15 drives the flexible display screen to expand outward, thus completing the expanding action of the flexible display screen. When the flexible display screen needs to retract, a user may click on the display screen of the electronic device to send a command "retract" to the terminal main board. The terminal main board transmits the command "retract" to the control circuit board 312, and the control circuit board 312 then controls the driving electric-machine to rotate (in a direction opposite to the direction of expanding rotation). The driving electric-machine amplifies the torque of the driving electric-machine through the reduction gearbox structure 32 and drives the second transmission member 15 to move linearly relative to the first transmission member 14. The second transmission member 15 drives the flexible display screen to retract to the starting position. In the present embodiment, the control circuit board 312 is connected to the driving electric-machine by welding, and the control circuit board 312 gets breakover with the terminal main board, or gets breakover with the main board terminal through a BTB connector to power on the driving electric-machine, and the driving electric-machine is controlled to rotate by a control signal.

Optionally, the driving electric-machine may be a DC stepper electric-machine which is an open-loop control electric-machine that converts an electric pulse signal into an angular displacement or a linear displacement. In the case of non-overload, the speed and stop position of the electric-machine only depend on frequency and pulse number of a pulse signal, and are not affected by load changes. When receiving one pulse signal, the stepper driver drives the stepper electric-machine to rotate by a fixed angle in a preset direction, and the rotation of the stepper electric-machine runs step by step at a fixed angle. The angular displacement may be controlled by controlling the pulse number, so as to achieve the purpose of accurate positioning. Moreover, the rotational speed and the rotational acceleration of the electric-machine may be controlled by controlling the pulse frequency, so as to regulate the speed and input the rotational torque.

The first transmission member 14 is a lead screw, the second transmission member 15 is a nut in threaded fit with the lead screw, and two ends of the lead screw are connected to the frame body 30 through bearings 141. The bracket 11 of the retractable screen structure is provided with a third transmission member 13. The lead screw extends along the first direction X, and the nut abuts against the third transmission member 13. The driving electric-machine drives the lead screw to rotate, and then drives the nut and the transmission member to move along the first direction X, thereby driving the sliding rail mechanism to move along the first direction X. It should be noted that the first transmission member and the second transmission member may also adopt structures such as gear racks, worm gears, and the like, which is not limited in the present disclosure.

Optionally, the driving mechanism 99 further includes a guide rod 33 arranged on the frame body 30, and the guide rod 33 is arranged in parallel with the lead screw. The nut includes a first sleeve portion 151 and a second sleeve portion 152, the first sleeve portion 151 is in threaded connection with the lead screw, and the second sleeve portion 152 is fitted over the guide rod 33. The second transmission member 15 is further provided with a protrusion 153 for abutting against the third transmission member 13 of the bracket 11 of the retractable screen structure. It may be understood that the nut is in threaded connection with the lead screw through the first sleeve portion 151, and when the lead screw rotates, the nut linearly moves relative to the lead screw. During the movement, the second sleeve portion 152 moves along the guide rod 33 to guide the nut.

Optionally, the driving member 31 includes an output shaft 311, and the reduction gearbox structure 32 includes a first reduction gearbox and a second reduction gearbox. The first reduction gearbox includes a first gear 321, the second reduction gearbox includes a second gear 322 and a third gear 323 (which may be understood as a lead screw gear) engaged with the second gear 322, the third gear 323 is connected with the first transmission member 14, the second gear 322 is engaged with the first gear 321, and the first gear 321 is connected with the output shaft 311. The output shaft 311 outputs a first torque to the first gear 321, and the first torque is converted into a second torque, by the second gear 322 and the third gear 323, to be output to the first transmission member 14. Through the gear engagement of the first gear 321, the second gear 322, and the third gear 323, a low torque output by the driving electric-machine may be converted into a high torque.

Optionally, the reduction gearbox structure 32 further includes a reduction gearbox end cover 34 fixedly connected to a side of the frame body 30. Optionally, a side of the frame body 30 is provided with a side frame 301 configured to be fixedly connected with the reduction gearbox end cover 34, and the reduction gearbox end cover 34 is fixed to the side frame 301. The gearbox end cover 34 is fixed to the side frame 301 by a plurality of fasteners 342 (e.g., screws). The first gear 321 and the second gear 322 are both connected to the reduction gearbox end cover 34, the third gear 323 is connected to the reduction gearbox end cover 34 through the first transmission member 14, and the reduction gearbox end cover 34 functions to fix the first gear 321, the second gear 322, the third gear 323 and the first transmission member 14.

Optionally, the first reduction gearbox includes a first bushing 324 fixed to the reduction gearbox end cover 34, and the first gear 321 is mounted to the first bushing 324. Optionally, the reduction gearbox end cover 34 is defined with a first through hole 341, the first bushing 324 is fixed in the first through hole 341, and the first gear 321 is a sun gear and is mounted to the first bushing 324. The second reduction gearbox includes a limit post 35 fixed to the reduction gearbox end cover 34, the second gear 322 is mounted to the limit post 35, and the limit post 35 functions to limit and fix the second gear 322.

Optionally, the first transmission member 14 is a lead screw, an end of the lead screw is connected to the reduction gearbox end cover 34 through the bearing 141, and the third gear 323 is engaged with the lead screw. Optionally, the reduction gearbox end cover 34 is further defined with a second through hole 343, the bearing 141 is mounted inside the second through hole 343, and an end of the lead screw is mounted to the bearing 141 so as to be fixed on the frame body 30.

Optionally, the first reduction gearbox further includes: a fixed gear ring 36, a driving gear 37, a planetary gear carrier 38 and a planetary gear 39.

The fixed gear ring 36 is connected to the driving member 31, and the output shaft 311 extends into the fixed gear ring 36.

The driving gear 37 is mounted in the fixed gear ring 36 and fixed to the output shaft 311. Optionally, the first reduction gearbox further includes a second bushing 371, and the driving gear 37 is mounted to the second bushing 371 to protect and limit the driving gear 37.

The planetary gear carrier 38 is mounted in the fixed gear ring 36 and is engaged with and fixed to the first gear 321. Optionally, the first reduction gearbox further includes a third bushing 381, and the planetary gear carrier 38 is mounted to the third bushing 381 to protect and limit the planetary gear carrier 38.

The planetary gear 39 is mounted on the planetary gear carrier 38 and is engaged with the driving gear 37.

The output shaft 311 outputs a first torque to the driving gear 37, and the first torque is reduced by the driving gear 37, the planetary gear 39, and the planetary gear carrier 38 and then transmitted to the first gear 321, achieving a first-level reduction effect. Then, the torque is reduced by the first gear 321 and then transmitted to the second gear 322, achieving a second-level reduction effect. Then, the torque is further reduced by the second gear 322 and then converted to the second torque and the second torque is transmitted to the third gear 323, achieving a third-level reduction effect. The third gear 323 transmits the second torque to the first transmission member 14 to drive the first transmission member 14 to rotate.

Based on the above arrangement, a first-level reduction gearbox is formed by the gear engagement of the driving gear 37, the planetary gear carrier 38 and the planetary gear 39. Through the gear engagement of the first gear 321, the second gear 322 and the third gear 323, second and third-level reduction gearboxes are formed. The planetary gear 39 may function as a first-level reduction gear, the first gear 321 may function as a second reduction gear, the second gear 322 may function as a third reduction gear, and the third gear 323 may function as a lead screw gear.

It may be understood that the first reduction gearbox is a core component of the driving mechanism. One end of the first reduction gearbox is mounted and welded to the driving electric-machine, and the other end of the first reduction gearbox is fixed to the frame body 30 by welding. The first reduction gearbox includes an output shaft 311 of the driving electric-machine, the driving gear 37, the second bushing 371, the planetary gear 39, the planetary gear carrier 38, the third bushing 381, the fixed gear ring 36, and the first gear 321. All parts are fixed by gear engagement, and the output shaft 311, the driving gear 37, the second bushing 371, the planetary gear 39, the planetary gear carrier 38, the third bushing 381 and the first gear 321 are all fixedly fitted inside the fixed gear ring. The driving gear 37 is fixed to the output shaft 311 of the driving electric-machine, the planetary gear carrier 38 and the first gear 321 are engaged and fixed to each other, and the other end of the first gear 321 is fixed to the first bushing 324, and is fixed to the reduction gearbox end cover 34 through the first bushing 324. The second gear 322 is fixed to the frame body 30 and the reduction gearbox end cover 34 through the limit post 35. The third gear 323 is fixed to the first transmission member 14, one end of the first transmission member 14 is fixed to the frame body 30 through a bearing 141, and the other end of the first transmission member 14 is also fixed to the reduction gearbox end cover 34 through a bearing 141. The reduction gearbox end cover 34 is fixed to the frame body 30 by a fastener 342, and the three gears (the first gear 321, the second gear 322 and the third gear 323) form second and third-level reduction gearboxes by gear engagement. The torque output by the driving electric-machine is reduced through the first reduction gearbox and the second reduction gearbox, and then a torque that is several or several tens of times greater than the output torque is output to the lead screw to drive the lead screw to rotate. The lead screw drives the nut to move. The reduction gearbox structure mainly functions to convert the low torque output by the driving electric-machine into a high torque.

In some alternative implementations, the frame body 30 may be manufactured by MIM (Powder Metallurgy), and apertures and some dimensions need to be processed by a lathe or a CNC machining center. The frame body 30 mainly functions to fix the reduction gearbox structure, the lead screws, the nuts, the bearings, the guide rod and other components. Therefore, the precision requirement and the flatness requirement for the frame body 30 are relatively high. The precision of the frame body 30 directly affects the stability of the entire driving mechanism. The entire frame body 30 may be fixed to the first housing 91 of the middle frame of the electronic device.

The nut may be made by MIM (Powder Metallurgy) and plastic two-color insert-molding, and the plastic herein is engineering plastic (POM material is commonly used), which has a self-lubricating effect. One end of the nut is fixed to the guide rod, and the other end of the nut is fixed to the lead screw. The end fixed to the lead screw needs to design a lead screw guide groove, so as to drive the nut to move linearly. According to the structural requirements of the push-out assembly, a bone position is designed on the nut to be connected and fixed to a side sliding member to push the sliding member to move. The guide rod may be made of stainless steel, which requires relatively high surface roughness, and the guide rod functions to guide and fix the nut. The lead screw is generally made of high-strength tool steel and is machined many times through a lathe or amachining center. Bearings are fixed at two ends of the lead screw, one end of the lead screw is fixed to the frame body, and the other end of the lead screw is fixed to the reduction gearbox end cover. The driving electric-machine drives the lead screw to rotate through the reduction gearbox structure, and the lead screw drives the nut to move linearly. Therefore, the strength and precision of the lead screw directly affect the stability and smoothness of the sliding member pushed by the nut.

Referring again to Figs. 14 to 16, due to the pre-tension of the elastic member of the elastic assembly, the sliding member 22 is pre-tensioned by the elastic assembly at the starting position, and due to the existence of the limit stopper 25, the sliding member 22 is kept in a static state at the starting position and the flexible display screen 90 is in a retracted state.

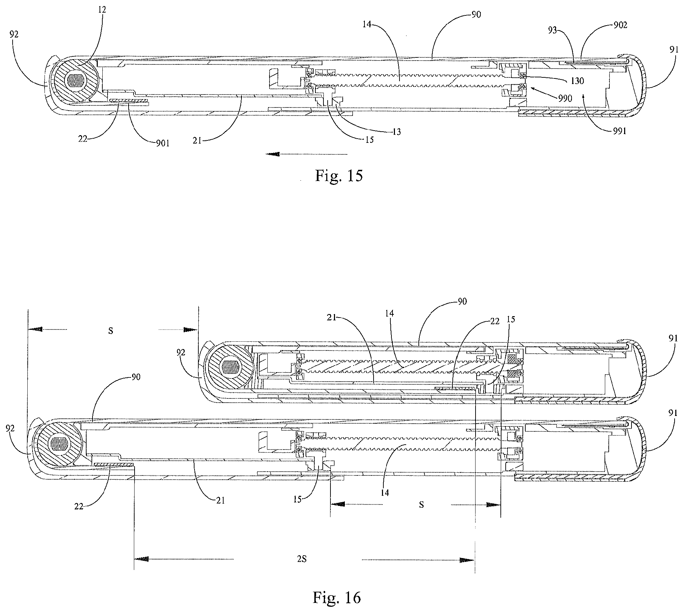

The driving mechanism is fixed to the middle frame (i.e., the housing) of the whole device as a power source. After receiving an instruction through UI, the electronic device controls the driving mechanism to drive the sliding rail mechanism to move along the first direction X (to the left as illustrated in Fig. 15) such that the whole sliding rail mechanism slides out relative to the first housing 91 in a direction away from the first housing 91. During this process, the first end of the flexible display screen 90 slides with the sliding member 22, and the rotating wheel of the rotating shaft assembly is passively rotated under the force of the flexible display screen 90. Since the second end of the flexible display screen 90 is connected with the first housing 91, as the sliding rail mechanism gradually slides out, an effect of gradually expanding the flexible display screen 90 may be achieved, as illustrated in Fig. 15. During the sliding process of the sliding rail mechanism, the sliding member 22 may be pulled by the flexible display screen to move from one end of the fixed base 21 to the other end, which may further extend the expanding length of the flexible display screen 90. In addition, during the sliding process, the elastic assembly is pulled by the sliding member 22 to generate an elastic pulling force to the sliding member 22 in a direction opposite to the sliding direction. The flexible display screen 90 is constantly subjected to the pulling force in the opposite direction, which is equivalent to pulling the flexible display screen 90 to the right, such that the stretched flexible display screen 90 becomes flatter. In this way, it may ensured that the flexible display screen 90 may move along a curving track according to the design intent, thereby preventing the visual problems such as bulging, swelling and distortion of the screen when the whole device is slid open. It may be understood that during the whole process, the sliding member 22 is pulled by the second end of the flexible display screen 90 to move from one end of the fixing base 21 to the other end. Assuming that the sliding stroke of the sliding rail mechanism relative to the first housing 91 is denoted as S and the sliding stroke of the sliding member 22 is denoted as S, the first end of the flexible display screen 90 moves a distance of 2S with the sliding rail mechanism relative to the first housing 91.
When the whole device receives an external instruction to retract, the drive motor starts to drive in a reverse direction to retract the sliding rail mechanism and the flexible display screen. During this process, the bracket and the fixed base are driven by the driving mechanism to move in the reverse direction. The flexible display screen and the sliding member are gradually retracted under the elastic force of the elastic assembly, and the sliding member returns to the starting position under the elastic force of the elastic assembly, thereby restoring the flexible display screen to the retracted state. Therefore, the sliding rail mechanism of the present invention may smoothly and effectively ensure that the flexible display screen maintains the curved shape in appearance during the sliding and retracting process of the whole device, and ensure that the power loss caused by the friction generated during the sliding and retracting process of the screen is at a relatively low level. The solution is operable and easy to implement and the product reliability may be ensured.

## Claims

1. An electronic device, comprising:
a housing comprising a first housing (91) and a second housing (92) slidably arranged on the first housing (91) along a first direction, the first housing (91) and the second housing (92) being enclosed to form a receiving structure with an opening;
a retractable screen structure arranged in the receiving structure, the retractable screen structure including a bracket (11) and a flexible display screen (90), a first end (901) of the flexible display screen (90) being located on a side close to bottom of the housing, a second end of the flexible display screen (90) being connected to the first housing (91) to cover the opening;
a rotating shaft assembly (12) arranged on a side of the bracket (11) away from the first housing (91), an axial direction of the rotating shaft assembly (12) being perpendicular to the first direction, and the flexible display screen (90) being wound on the rotating shaft assembly (12); and
a driving mechanism (99) arranged in the receiving structure, the driving mechanism (99) being connected to the bracket (11) and configured to drive the bracket (11) to move along the first direction;
**characterized in that**:
the electronic device comprises a sliding rail assembly (20) slidably arranged on the bracket (11) along the first direction,
wherein the sliding rail assembly (20) is connected to the first end (901) of the flexible display screen (90),
when the flexible display screen (90) moves along the first direction, the flexible display screen (90) driving the sliding rail assembly (20) to slide along the first direction relative to the bracket (11),
wherein the sliding rail assembly (20) comprises a fixed base (21) fixedly connected to the bracket (11), a sliding member (22) slidingly arranged on the fixed base (21), and an elastic assembly (23) to generate a reverse tension force;
wherein the first end (901) of the flexible display screen (90) is connected to the sliding member (22);
wherein the driving mechanism (99) drives the bracket (11) to move along the first direction, so as to drive the second housing (92), the sliding member (22), and the first end (901) of the flexible display screen (90) to move along the first direction relative to the first housing (91), such that the flexible display screen (90) is switched between a retracted state and an expanded state, and
wherein the driving mechanism (99) comprises a frame body (30), a driving assembly and a transmission assembly, both the driving assembly and the transmission assembly being mounted on the frame body (30);
the driving assembly comprises a driving member (31) and a reduction gearbox structure (32) connected to the driving member (31), both the driving member (31) and the reduction gearbox structure (32) being mounted to the frame body (30);
the transmission assembly comprises a first transmission member (14) and a second transmission member (15) movably connected to the first transmission member (14), the first transmission member (14) being mounted to the frame body (30) and connected to the reduction gearbox structure (32), the second transmission member (15) being configured to be in transmission connection with a flexible display screen (90) of the retractable screen structure;
the driving member (31) is configured to output a first torque to the reduction gearbox structure (32), the reduction gearbox structure (32) is configured to convert the first torque into a second torque and output the second torque to the first transmission member (14) to drive the first transmission member (14) to rotate, and the second transmission member (15) is configured to move relative to the first transmission member (14) to drive the flexible display screen (90) to move, wherein the first torque is less than the second torque.

2. The electronic device according to claim 1, wherein the first transmission member (14) is a lead screw, the second transmission member (15) is a nut in threaded fit with the lead screw, and two ends of the lead screw are connected to the frame body (30) through bearings.

3. The electronic device according to claim 2, wherein the driving mechanism (99) further comprises a guide rod (33) arranged on the frame body (30), the guide rod (33) being arranged in parallel with the lead screw;
the nut comprises a first sleeve portion (151) and a second sleeve portion (152), the first sleeve portion (151) is in threaded connection with the lead screw, and the second sleeve portion (152) is fitted over the guide rod (33).

4. The electronic device according to any one of claims 1 to 3, wherein the driving member (31) comprises an output shaft (311), and the reduction gearbox structure (32) comprises a first reduction gearbox and a second reduction gearbox;
the first reduction gearbox comprises a first gear (321), the second reduction gearbox comprises a second gear (322) and a third gear (323) engaged with the second gear (322), the third gear (323) is connected with the first transmission member (14), the second gear (322) is engaged with the first gear (321), and the first gear (321) is connected with the output shaft (311);
the output shaft (311) outputs a first torque to the first gear (321), and the first torque is converted into a second torque, by the second gear (322) and the third gear (323), to be output to the first transmission member (14).

5. The electronic device according to claim 4, wherein the reduction gearbox structure (32) further comprises a reduction gearbox end cover (34) fixedly connected to a side of the frame body (30);
the first gear (321) and the second gear (322) are both connected to the reduction gearbox end cover (34), and the third gear (323) is connected to the reduction gearbox end cover (34) through the first transmission member (14).

6. The electronic device according to claim 5, wherein the first reduction gearbox comprises a first bushing (324) fixed to the reduction gearbox end cover (34), and the first gear (321) is mounted to the first bushing (324).

7. The electronic device according to claim 5 or 6, wherein the second reduction gearbox comprises a limit post (35) fixed to the reduction gearbox end cover (34), and the second gear (322) is mounted to the limit post (35).

8. The electronic device according to any one of claims 5 to 7, wherein the first transmission member (14) is a lead screw, a first end of the lead screw is connected to the reduction gearbox end cover (34) through a first bearing, and the third gear (323) is engaged with the lead screw.

9. The electronic device according to any one of claims 4 to 8, wherein the first reduction gearbox further comprises:
a fixed gear ring (36) connected to the driving member (31), the output shaft (311) extending into the fixed gear ring (36);
a driving gear (37) mounted in the fixed gear ring (36) and fixed to the output shaft (311);
a planetary gear carrier (38) mounted in the fixed gear ring (36) and engaged with and fixed to the first gear (321); and
a planetary gear (39) mounted on the planetary gear carrier (38) and engaged with the driving gear (37);
the output shaft (311) outputting a first torque to the driving gear (37), the first torque being transmitted to the second gear (322) by the driving gear (37), the planetary gear (39), and the planetary gear carrier (38).

10. The electronic device according to claim 6, wherein the reduction gearbox end cover (34) is defined with a first through hole (341), the first bushing (324) is fixed in the first through hole (341), and the first gear (321) is a sun gear and is mounted to the first bushing (324).

11. The electronic device according to any one of claims 5 to 8, wherein the reduction gearbox end cover (34) is further defined with a second through hole (343), a second bearing is mounted inside the second through hole (343), and a second end of the lead screw is mounted to the second bearing to be fixed on the frame body (30).

12. The electronic device according to any one of claims 1 to 11, wherein the bracket (11) of the retractable screen structure is provided with a third transmission member (13), and the second transmission member (15) is further provided with a protrusion (153) for abutting against the third transmission member (13) of the bracket (11) of the retractable screen structure.

13. The electronic device according to any one of claims 1 to 12, wherein the electronic device comprises two driving mechanisms (99).

## Patentansprüche

1. Elektronische Vorrichtung, die aufweist:
ein Gehäuse, das ein erstes Gehäuse (91) und ein zweites Gehäuse (92) aufweist, wobei das zweite Gehäuse (92) entlang einer ersten Richtung verschiebbar an dem ersten Gehäuse (91) angeordnet ist und das erste Gehäuse (91) und das zweite Gehäuse (92) umschlossen sind, um eine Aufnahmestruktur mit einer Öffnung zu bilden;
eine einziehbare Bildschirmstruktur, die in der Aufnahmestruktur angeordnet ist, wobei die einziehbare Bildschirmstruktur einen Halter (11) und einen flexiblen Anzeigebildschirm (90) aufweist, wobei sich ein erstes Ende (901) des flexiblen Anzeigebildschirms (90) auf einer Seite nahe dem Boden des Gehäuses befindet und ein zweites Ende des flexiblen Anzeigebildschirms (90) mit dem ersten Gehäuse (91) verbunden ist, um die Öffnung abzudecken;
eine Drehwellenbaugruppe (12), die auf einer von dem ersten Gehäuse (91) abgewandten Seite des Halters (11) angeordnet ist, wobei eine axiale Richtung der Drehwellenbaugruppe (12) senkrecht zur ersten Richtung verläuft und der flexible Anzeigebildschirm (90) um die Drehwellenbaugruppe (12) gewickelt ist; und
einen Antriebsmechanismus (99), der in der Aufnahmestruktur angeordnet ist, wobei der Antriebsmechanismus (99) mit dem Halter (11) verbunden und dazu ausgebildet ist, den Halter (11) zu einer Bewegung entlang der ersten Richtung anzutreiben;
**dadurch gekennzeichnet, dass**
die elektronische Vorrichtung eine Gleitschienenbaugruppe (20) aufweist, die entlang der ersten Richtung verschiebbar an dem Halter (11) angeordnet ist, wobei die Gleitschienenbaugruppe (20) mit dem ersten Ende (901) des flexiblen Anzeigebildschirms (90) verbunden ist,
wobei, wenn sich der flexible Anzeigebildschirm (90) entlang der ersten Richtung bewegt, der flexible Anzeigebildschirm (90) die Gleitschienenbaugruppe (20) relativ zum Halter (11) entlang der ersten Richtung gleitend antreibt, wobei die Gleitschienenbaugruppe (20) eine feststehende Basis (21), die fest mit dem Halter (11) verbunden ist, ein Gleitelement (22), das gleitend an der feststehenden Basis (21) angeordnet ist, und eine elastische Baugruppe (23) zum Erzeugen einer entgegengesetzten Zugkraft aufweist;
wobei das erste Ende (901) des flexiblen Anzeigebildschirms (90) mit dem Gleitelement (22) verbunden ist;
wobei der Antriebsmechanismus (99) den Halter (11) zu einer Bewegung entlang der ersten Richtung antreibt, um dadurch das zweite Gehäuse (92), das Gleitelement (22) und das erste Ende (901) des flexiblen Anzeigebildschirms (90) entlang der ersten Richtung relativ zum ersten Gehäuse (91) zu bewegen, so dass der flexible Anzeigebildschirm (90) zwischen einem eingezogenen Zustand und einem ausgefahrenen Zustand umgeschaltet wird, und
wobei der Antriebsmechanismus (99) einen Rahmenkörper (30), eine Antriebsbaugruppe und eine Übertragungsbaugruppe aufweist, wobei sowohl die Antriebsbaugruppe als auch die Übertragungsbaugruppe an dem Rahmenkörper (30) angebracht sind;
die Antriebsbaugruppe ein Antriebselement (31) und eine mit dem Antriebselement (31) verbundene Untersetzungsgetriebestruktur (32) aufweist, wobei sowohl das Antriebselement (31) als auch die Untersetzungsgetriebestruktur (32) an dem Rahmenkörper (30) angebracht sind;
die Übertragungsbaugruppe ein erstes Übertragungselement (14) und ein zweites Übertragungselement (15) aufweist, das beweglich mit dem ersten Übertragungselement (14) verbunden ist, wobei das erste Übertragungselement (14) an dem Rahmenkörper (30) angebracht und mit der Untersetzungsgetriebestruktur (32) verbunden ist und das zweite Übertragungselement (15) dazu ausgebildet ist, in Übertragungsverbindung mit einem flexiblen Anzeigebildschirm (90) der einziehbaren Bildschirmstruktur zu stehen;
das Antriebselement (31) dazu ausgebildet ist, ein erstes Drehmoment an die Untersetzungsgetriebestruktur (32) auszugeben, die Untersetzungsgetriebestruktur (32) dazu ausgebildet ist, das erste Drehmoment in ein zweites Drehmoment umzuwandeln und das zweite Drehmoment an das erste Übertragungselement (14) auszugeben, um das erste Übertragungselement (14) zur Drehung anzutreiben, und das zweite Übertragungselement (15) dazu ausgebildet ist, sich relativ zum ersten Übertragungselement (14) zu bewegen, um den flexiblen Anzeigebildschirm (90) zu einer Bewegung anzutreiben, wobei das erste Drehmoment kleiner als das zweite Drehmoment ist.

2. Elektronische Vorrichtung nach Anspruch 1, wobei das erste Übertragungselement (14) eine Gewindespindel ist, das zweite Übertragungselement (15) eine Mutter ist, die mit der Gewindespindel in Gewindeeingriff steht, und die beiden Enden der Gewindespindel über Lager mit dem Rahmenkörper (30) verbunden sind.

3. Elektronische Vorrichtung nach Anspruch 2, wobei der Antriebsmechanismus (99) ferner eine an dem Rahmenkörper (30) angeordnete Führungsstange (33) aufweist, wobei die Führungsstange (33) parallel zur Gewindespindel angeordnet ist;
die Mutter einen ersten Hülsenabschnitt (151) und einen zweiten Hülsenabschnitt (152) aufweist, wobei der erste Hülsenabschnitt (151) in Gewindeverbindung mit der Gewindespindel steht und der zweite Hülsenabschnitt (152) auf die Führungsstange (33) aufgesetzt ist.

4. Elektronische Vorrichtung nach einem der Ansprüche 1 bis 3, wobei das Antriebselement (31) eine Ausgangswelle (311) aufweist und die Untersetzungsgetriebestruktur (32) ein erstes Untersetzungsgetriebe und ein zweites Untersetzungsgetriebe aufweist;
das erste Untersetzungsgetriebe ein erstes Zahnrad (321) aufweist, das zweite Untersetzungsgetriebe ein zweites Zahnrad (322) und ein drittes Zahnrad (323) aufweist, das mit dem zweiten Zahnrad (322) in Eingriff steht, das dritte Zahnrad (323) mit dem ersten Übertragungselement (14) verbunden ist, das zweite Zahnrad (322) mit dem ersten Zahnrad (321) in Eingriff steht und das erste Zahnrad (321) mit der Ausgangswelle (311) verbunden ist;
die Ausgangswelle (311) ein erstes Drehmoment an das erste Zahnrad (321) ausgibt und das erste Drehmoment durch das zweite Zahnrad (322) und das dritte Zahnrad (323) in ein zweites Drehmoment umgewandelt wird, um an das erste Übertragungselement (14) ausgegeben zu werden.

5. Elektronische Vorrichtung nach Anspruch 4, wobei die Untersetzungsgetriebestruktur (32) ferner einen Untersetzungsgetriebe-Enddeckel (34) aufweist, der fest mit einer Seite des Rahmenkörpers (30) verbunden ist;
sowohl das erste Zahnrad (321) als auch das zweite Zahnrad (322) mit dem Untersetzungsgetriebe-Enddeckel (34) verbunden sind und das dritte Zahnrad (323) über das erste Übertragungselement (14) mit dem Untersetzungsgetriebe-Enddeckel (34) verbunden ist.

6. Elektronische Vorrichtung nach Anspruch 5, wobei das erste Untersetzungsgetriebe eine erste Buchse (324) aufweist, die an dem Untersetzungsgetriebe-Enddeckel (34) befestigt ist, und das erste Zahnrad (321) an der ersten Buchse (324) angebracht ist.

7. Elektronische Vorrichtung nach Anspruch 5 oder 6, wobei das zweite Untersetzungsgetriebe einen Begrenzungsstift (35) aufweist, der an dem Untersetzungsgetriebe-Enddeckel (34) befestigt ist, und das zweite Zahnrad (322) an dem Begrenzungsstift (35) angebracht ist.

8. Elektronische Vorrichtung nach einem der Ansprüche 5 bis 7, wobei das erste Übertragungselement (14) eine Gewindespindel ist, ein erstes Ende der Gewindespindel über ein erstes Lager mit dem Untersetzungsgetriebe-Enddeckel (34) verbunden ist und das dritte Zahnrad (323) mit der Gewindespindel in Eingriff steht.

9. Elektronische Vorrichtung nach einem der Ansprüche 4 bis 8, wobei das erste Untersetzungsgetriebe ferner aufweist:
einen feststehenden Zahnkranz (36), der mit dem Antriebselement (31) verbunden ist, wobei sich die Ausgangswelle (311) in den feststehenden Zahnkranz (36) erstreckt;
ein Antriebszahnrad (37), das in dem feststehenden Zahnkranz (36) angebracht und an der Ausgangswelle (311) befestigt ist;
einen Planetenradträger (38), der in dem feststehenden Zahnkranz (36) angebracht ist und mit dem ersten Zahnrad (321) in Eingriff steht und daran befestigt ist; und
ein Planetenrad (39), das an dem Planetenradträger (38) angebracht ist und
mit dem Antriebszahnrad (37) in Eingriff steht;
wobei die Ausgangswelle (311) ein erstes Drehmoment an das Antriebszahnrad (37) ausgibt und das erste Drehmoment mittels des Antriebszahnrads (37), des Planetenrads (39) und des Planetenradträgers (38) an das zweite Zahnrad (322) übertragen wird.

10. Elektronische Vorrichtung nach Anspruch 6, wobei der Untersetzungsgetriebe-Enddeckel (34) mit einem ersten Durchgangsloch (341) ausgebildet ist, die erste Buchse (324) in dem ersten Durchgangsloch (341) befestigt ist und das erste Zahnrad (321) ein Sonnenrad ist und an der ersten Buchse (324) angebracht ist.

11. Elektronische Vorrichtung nach einem der Ansprüche 5 bis 8, wobei der Untersetzungsgetriebe-Enddeckel (34) ferner mit einem zweiten Durchgangsloch (343) ausgebildet ist, ein zweites Lager innerhalb des zweiten Durchgangslochs (343) angebracht ist und ein zweites Ende der Gewindespindel an dem zweiten Lager angebracht ist, um an dem Rahmenkörper (30) befestigt zu sein.

12. Elektronische Vorrichtung nach einem der Ansprüche 1 bis 11, wobei der Halter (11) der einziehbaren Bildschirmstruktur mit einem dritten Übertragungselement (13) versehen ist und das zweite Übertragungselement (15) ferner mit einem Vorsprung (153) zum Anliegen an dem dritten Übertragungselement (13) des Halters (11) der einziehbaren Bildschirmstruktur versehen ist.

13. Elektronische Vorrichtung nach einem der Ansprüche 1 bis 12, wobei die elektronische Vorrichtung zwei Antriebsmechanismen (99) aufweist.

## Revendications

1. Dispositif électronique, comprenant :
une coque comprenant un premier boîtier (91) et un second boîtier (92) disposé coulissant sur le premier boîtier (91) dans un premier sens, le premier boîtier (91) et le second boîtier (92) étant fermés pour former une structure de réception dotée d'une ouverture ;
une structure d'écran rétractable disposée dans la structure de réception, la structure d'écran rétractable comprenant un support (11) et un écran d'affichage souple (90), une première extrémité (901) de l'écran d'affichage souple (90) étant située d'un côté proche d'une partie inférieure de la coque, une seconde extrémité de l'écran d'affichage souple (90) étant reliée au premier boîtier (91) pour couvrir l'ouverture ;
un ensemble arbre tournant (12) disposé d'un côté du support (11) opposé au premier boîtier (91), une direction axiale de l'ensemble arbre tournant (12) étant perpendiculaire au premier sens, et l'écran d'affichage souple (90) étant enroulé sur l'ensemble arbre tournant (12) ; et
un mécanisme d'entraînement (99) disposé dans la structure de réception, le mécanisme d'entraînement (99) étant en prise avec le support (11) et étant configuré pour entraîner le support (11) pour qu'il se déplace dans le premier sens ;
**caractérisé en ce que** :
le dispositif électronique comprend un ensemble rail coulissant (20), disposé coulissant sur le support (11) dans le premier sens,
dans lequel l'ensemble rail coulissant (20) est relié à la première extrémité (901) de l'écran d'affichage souple (90),
lorsque l'écran d'affichage souple (90) se déplace dans le premier sens, l'écran d'affichage souple (90) entraîne l'ensemble rail coulissant (20) pour qu'il coulisse dans le premier sens par rapport au support (11),
dans lequel l'ensemble rail coulissant (20) comprend une base fixe (21) reliée de manière solidaire au support (11), un élément coulissant (22) étant disposé coulissant sur la base fixe (21), et un ensemble élastique (23) servant à générer une force de traction inverse ;
dans lequel la première extrémité (901) de l'écran d'affichage souple (90) est reliée à l'élément coulissant (22) ;
dans lequel le mécanisme d'entraînement (99) entraîne le support (11) pour qu'il se déplace dans le premier sens, de façon à entraîner le second boîtier (92), l'élément coulissant (22) et la première extrémité (901) de l'écran d'affichage souple (90) pour qu'ils se déplacent dans le premier sens par rapport au premier boîtier (91), de sorte que l'écran d'affichage souple (90) passe d'un état en retrait à un état déployé, et
dans lequel le mécanisme d'entraînement (99) comprend un corps de châssis (30), un ensemble d'entraînement et un ensemble de transmission, l'ensemble d'entraînement et l'ensemble de transmission étant tous deux montés sur le corps de châssis (30) ;
l'ensemble d'entraînement comprend un élément d'entraînement (31) et une structure de réducteurs (32) en prise avec l'élément d'entraînement (31), l'élément d'entraînement (31) et la structure de réducteurs (32) étant tout deux montés sur le corps de châssis (30) ;
l'ensemble de transmission comprend un premier élément de transmission (14) et un deuxième élément de transmission (15) en prise mobile avec le premier élément de transmission (14), le premier élément de transmission (14) étant monté sur le corps de châssis (30) et étant en prise avec la structure de réducteurs (32), le deuxième élément de transmission (15) étant configuré pour être en prise de transmission avec un écran d'affichage souple (90) de la structure d'écran rétractable ;
l'élément d'entraînement (31) est configuré pour délivrer un premier couple à la structure de réducteurs (32), la structure de réducteurs (32) est configurée pour convertir le premier couple en un second couple et pour délivrer le second couple au premier élément de transmission (14) pour entraîner en rotation le premier élément de transmission (14), et le deuxième élément de transmission (15) est configuré pour se déplacer par rapport au premier élément de transmission (14) pour entraîner l'écran d'affichage souple (90) de sorte qu'il se déplace lorsque le premier couple est inférieur au second couple.

2. Dispositif électronique selon la revendication 1, dans lequel le premier élément de transmission (14) est une vis mère, et le deuxième élément de transmission (15) est un écrou ajusté par filetage à la vis mère, et deux extrémités de la vis mère sont reliées au corps de châssis (30) par l'intermédiaire de paliers.

3. Dispositif électronique selon la revendication 2, dans lequel le mécanisme d'entraînement (99) comprend en outre une tige de guidage (33) disposée sur le corps de châssis (30), la tige de guidage (33) étant disposée parallèlement à la vis mère ;
l'écrou comprend une première partie manchon (151) et une seconde partie manchon (152), la première partie manchon (151) étant en prise par vissage avec la vis mère, et la seconde partie manchon (152) étant ajustée sur la tige de guidage (33).

4. Dispositif électronique selon l'une quelconque des revendications 1 à 3, dans lequel l'élément d'entraînement (31) comprend un arbre de sortie (311), et la structure de réducteurs (32) comprend un premier réducteur et un second réducteur ;
le premier réducteur comprend un premier pignon (321), le second réducteur comprend un deuxième pignon (322) et un troisième pignon (323) en prise avec le deuxième pignon (322), le troisième pignon (323) est en prise avec le premier élément de transmission (14), le deuxième pignon (322) est en prise avec le premier pignon (321), et le premier pignon (321) est en prise avec l'arbre de sortie (311) ;
l'arbre de sortie (311) délivre un premier couple au premier pignon (321), et le premier couple est converti en un second couple, par le deuxième pignon (322) et le troisième pignon (323), pour être délivré au premier élément de transmission (14).

5. Dispositif électronique selon la revendication 4, dans lequel la structure de réducteurs (32) comprend en outre un couvercle d'extrémité de réducteurs (34) relié de manière solidaire à un côté du corps de châssis (30) ;
le premier pignon (321) et le deuxième pignon (322) sont tous les deux reliés au couvercle d'extrémité de réducteurs (34) et le troisième pignon (323) est relié au couvercle d'extrémité de réducteurs (34) par l'intermédiaire du premier élément de transmission (14).

6. Dispositif électronique selon la revendication 5, dans lequel le premier réducteur comprend une première bague de palier (324) fixée au couvercle d'extrémité de réducteurs (34), et le premier pignon (321) est monté sur la première bague de palier (324).

7. Dispositif électronique selon la revendication 5 ou la revendication 6, dans lequel le second réducteur comprend un tenon de limitation (35) fixé au couvercle d'extrémité de réducteurs (34), et le deuxième pignon (322) est monté sur le tenon de limitation (35).

8. Dispositif électronique selon l'une quelconque des revendications 5 à 7, dans lequel le premier élément de transmission (14) est une vis mère, une première extrémité de la vis mère est reliée au couvercle d'extrémité de réducteurs (34) par l'intermédiaire d'un premier palier, et le troisième pignon (323) est en prise avec la vis mère.

9. Dispositif électronique selon l'une quelconque des revendications 4 à 8, dans lequel le premier réducteur comprend en outre :
une couronne fixe de réducteur (36) en prise avec l'élément d'entraînement (31), l'arbre de sortie (311) s'étendant dans la première couronne fixe de réducteur (36) ;
un pignon d'entraînement (37) monté dans la couronne fixe de réducteur (36) et fixé à l'arbre de sortie (311) ;
un support de train planétaire (38) monté dans la couronne fixe de réducteur (36) et en prise avec le premier pignon (321), et fixé à ce dernier ; et
un train planétaire (39) monté sur le support de train planétaire (38) et en prise avec le pignon d'entraînement (37) ;
l'arbre de sortie (311) délivrant un premier couple au pignon d'entraînement (37), le premier couple étant transmis au deuxième pignon (322) par le pignon d'entraînement (37), par le train planétaire (39) et par le support de train planétaire (38).

10. Dispositif électronique selon la revendication 6, dans lequel le couvercle d'extrémité de réducteurs (34) est défini avec un premier trou traversant (341), la première bague de palier (324) est fixée dans le premier trou traversant (341), et le premier pignon (321) est une couronne mobile et est monté sur la première bague de palier (324).

11. Dispositif électronique selon l'une quelconque des revendications 5 à 8, dans lequel le couvercle d'extrémité de réducteurs (34) est en outre défini avec un second trou traversant (343), un second palier est monté à l'intérieur du second trou traversant (343), et une seconde extrémité de la vis mère est montée sur le second palier pour être fixée au corps de châssis (30).

12. Dispositif électronique selon l'une quelconque des revendications 1 à 11, dans lequel le support (11) de la structure d'écran rétractable est pourvue d'un troisième élément de transmission (13), et le deuxième élément de transmission (15) est en outre pourvu d'une saillie (153) destinée à venir en butée contre le troisième élément de transmission (13) du support (11) de la structure d'écran rétractable.

13. Dispositif électronique selon l'une quelconque des revendications 1 à 12, dans lequel le dispositif électronique comprend deux mécanismes d'entraînement (99).
